# EUROPEAN PATENT SPECIFICATION

(11) **EP 1 925 016 B1**
(45) Date of publication and mention of the grant of the patent: **07.07.2010**
(21) Application number: 06810135.1
(22) Date of filing: 07.09.2006
(51) Int. Cl.: H01J 37/32

(54) **PLASMA PROCESSING APPARATUS**
PLASMAVERARBEITUNGSVORRICHTUNG
APPAREIL DE TRAITEMENT AU PLASMA

(30) Priority: 12.09.2005 JP 2005263409
(43) Date of publication of application: 28.05.2008
(73) Proprietor: Panasonic Corporation, Kadoma-shi Osaka 571-8501 (JP)
(72) Inventor: IWAI, Tetsuhiro, c/o Matsushita Electric Ind. Co., Ltd., Chuo-ku, Osaka-shi, Osaka 540-6207 (JP)
(74) Representative: Grünecker, Kinkeldey, Stockmair & Schwanhäusser Anwaltssozietät
(86) International application number: PCT/JP2006/318229
(87) International publication number: WO 2007/032420

(56) References cited:
- WO-A-01/52302
- JP-A- 2000 208 483
- JP-A- 2004 165 674
- US-A- 4 209 357
- US-A1- 2004 050 496
- US-A1- 2004 182 515
- US-A1- 2005 034 815

## Description

### Technical Field

The present invention relates to a plasma processing apparatus for processing a work in a plate-like shape such as a semiconductor wafer by plasma.

### Background Art

A semiconductor device to be mounted on a circuit board of an electronic apparatus or the like is manufactured, by cutting a semiconductor element in a wafer state on which circuit patterns have been formed, into individual pieces. In recent years, as the semiconductor element has become thinner and thinner, a method of conducting dicing process for cutting the semiconductor element in the wafer state and dividing it into individual pieces, stress relieving process after mechanical polishing for thinning the semiconductor, and other processes by plasma has become widely employed.

As a plasma processing apparatus to be employed in such method, there has been known a plasma processing apparatus which is so constructed that an upper electrode is arranged so as to move up and down with respect to a lower electrode (Reference should be made to U.S. Patent 6,511,917, for example). By employing such a structure, there have been advantages that when a semiconductor wafer is placed on the lower electrode to conduct the plasma process, an optimum distance can be set between the electrodes, and that when the semiconductor wafer is conveyed, an appropriate clearance for the conveying operation can be secured, by moving the upper electrode upwardly.

However, the plasma processing apparatus as disclosed in the above described patent document has had the following problems in efficiently conducting stabilized plasma process. Specifically, in the structure where the upper electrode can be moved up and down in a vacuum chamber for generating plasma discharge, a space for assuring vertical movements of the upper electrode must be provided above the upper electrode in the vacuum chamber. In this space above the upper electrode, it is inevitable that abnormal discharge may be induced, depending on conditions of plasma discharge. This abnormal discharge has been factors responsible for loss of electric power for generating the plasma discharge and scattering of the plasma discharge, which have hindered efficient performance of stabilized plasma process.

US 4 209 357 discloses a plasma chamber with opposing electrodes, so configured that plasma reaction takes place only between the electrodes. The lower electrode wich serves as a workpiece holder is vertically movable to permit loading and unloading of the workpiece.

### Disclosure of Invention

Under the circumstances, it is an object of the invention to provide a plasma processing apparatus which can efficiently perform stabilized plasma process.

A plasma processing apparatus according to the invention is a plasma processing apparatus for conducting plasma process on a work in a plate-like shape, which includes a vacuum chamber formed of a cylindrical container as a main body which has a side wall part continued in an annular shape, a supply port which is opened in the side wall part for putting into and taking out the work, and a hermetically sealing face which is formed in the side wall part at a position higher than the supply port, a door which can be opened and closed for hermetically sealing the supply port, a lower electrode which is disposed in a bottom part of the vacuum chamber surrounded by the side wall part, the work being adapted to be placed on an upper face of the lower electrode, an upper electrode provided with an annular outer edge portion which can be brought into contact with the hermetically sealing face, and a projected face which is projected downward from its lower face inward of the outer edge portion to a position lower than a lower face of the outer edge portion, an elevating mechanism for moving the upper electrode up and down to bring the outer edge portion into contact with the hermetically sealing face thereby to form a hermetically sealed process space between the lower electrode and the upper electrode, and plasma generating means for generating plasma in the process space.

According to the invention, there is employed the structure where the upper electrode provided with the projected face which is projected downward from its lower face inward of the outer edge portion to a position lower than the lower face of the outer edge portion is moved downward with respect to the lower electrode, to bring the outer edge portion of the upper electrode into contact with the annular hermetically sealing face which is formed in the vacuum chamber, whereby the hermetically sealed process space is formed between the lower electrode and the upper electrode. Therefore, it is possible to prevent occurrence of abnormal discharge above the upper electrode, and to efficiently perform the stabilized plasma process.

### Brief Description of Drawings

Fig. 1 is an explanatory view showing structure of a plasma processing apparatus in an embodiment of the invention.
Fig. 2 is a sectional side view showing a vacuum chamber in the plasma processing apparatus in the embodiment of the invention.
Fig. 3 is a sectional side view showing the vacuum chamber in the plasma processing apparatus in the embodiment of the invention.
Fig. 4 is a plan view showing the vacuum chamber in the plasma processing apparatus in the embodiment of the invention.
Fig. 5 is a sectional view showing a part of the vacuum chamber in the plasma processing apparatus in the embodiment of the invention.
Fig. 6 is a sectional side view showing a lower electrode in the plasma processing apparatus in the embodiment of the invention.
Fig. 7 is a plan view showing a sucking member in the plasma processing apparatus in the embodiment of the invention.
Fig. 8 is a bottom view of the sucking member in the plasma processing apparatus in the embodiment of the invention.
Fig. 9 is a view for explaining operation of an upper electrode in the plasma processing apparatus in the embodiment of the invention.
Fig. 10 is a view for explaining opening and closing operation of the vacuum chamber in the plasma processing apparatus in the embodiment of the invention.
Fig. 11 is a flow chart showing a process for producing an electrode member which is used in the plasma processing apparatus in the embodiment of the invention.
Fig. 12 is a view for explaining the process for producing the electrode member which is used in the plasma processing apparatus in the embodiment of the invention.
Fig. 13 is a view for explaining the process for producing the electrode member which is used in the plasma processing apparatus in the embodiment of the invention.

### Description of the Reference Numerals and Signs

- 1: plasma treating apparatus
- 2: vacuum chamber
- 2a: processing space
- 3: lower electrode
- 4: upper electrode
- 5: semiconductor wafer
- 6: upper plate
- 7: up-down driving portion
- 9: door member
- 11: vacuum pump
- 13: process gas supply portion
- 17: high frequency power supply
- 40: chamber container
- 40a: sidewall part
- 40d: sealing face
- 40f: supply port
- 44: cooling plate
- 45: suction member
- 45a: through hole
- 46: electrode member
- 50: holding member
- 51: intermediate plate
- 51a: outer edge portion
- 59: hinge shaft
- 65: sprayed film

### Best Mode for Carrying Out the Invention

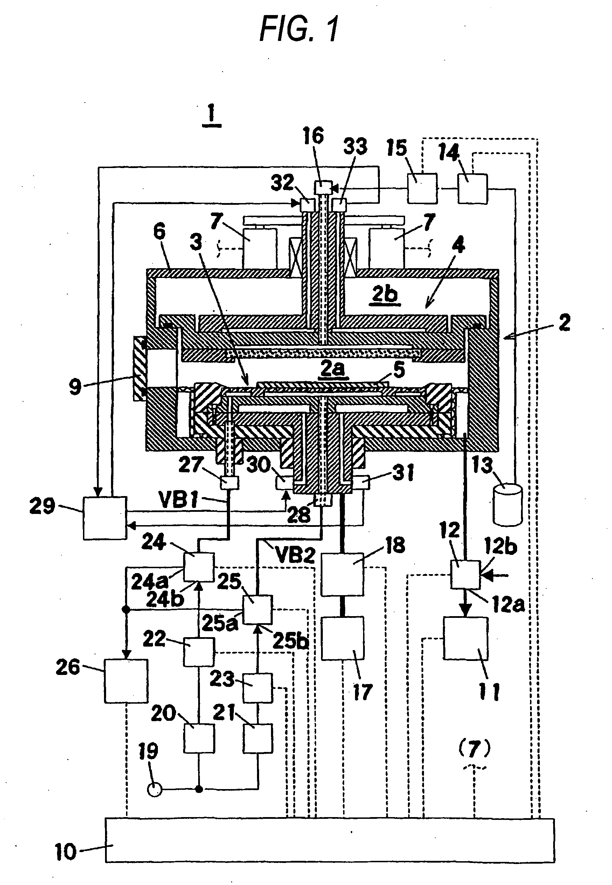

Now, an embodiment of the invention will be described referring to the drawings.
To begin with, an entire structure of a plasma processing apparatus 1 will be described referring to Fig. 1. The plasma processing apparatus 1 has a function of conducting plasma process on a work in a plate-like shape such as a semiconductor wafer. The plasma processing apparatus 1 has a vacuum chamber 2 for generating plasma under a reduced pressure. Inside the vacuum chamber 2, there is disposed a lower electrode 3 on which a semiconductor wafer 5 as the work is placed, and an upper electrode 4 is arranged above the lower electrode 3 so as to move up and down. The upper electrode 4 moves up and down by an elevation actuating part 7 provided on an upper plate 6 which is in contact with an upper part of the vacuum chamber 2, whereby a hermetically sealed process space 2a is formed between the lower electrode 3 and the upper electrode 4, in a state where the upper electrode 4 has been lowered. In this state, an area above the upper electrode 4 will be a normal pressure space 2b separated from the process space 2a, where plasma discharge will not occur.

On a side face of the vacuum chamber 2, there is provided a supply port for putting into and taking out the work, which is closed with a door 9. By opening the door 9, it is possible to put the semiconductor wafer 5 into or out of the processing space 2a. Then, the plasma will be generated in the process space 2a by plasma generating means which will be described below, and the plasma process will be conducted on the semiconductor wafer 5 which has been placed on the lower electrode 3. In this embodiment, by plasma-etching the semiconductor wafer 5 to which masking with a resist film has been applied, plasma-dicing for dividing the semiconductor wafer 5 into individual pieces, and plasma-ashing for removing the resist film by the plasma process, after the plasma-dicing, will be conducted.

A selection valve 12 is connected to an internal space in the vacuum chamber 2, and a vacuum pump 11 is connected to a suction port 12a of the selection valve 12. By actuating the vacuum pump 11 in a state where the selection valve 12 has been switched to the suction port 12a, the internal space in the vacuum chamber 2 will be evacuated. Alternatively, by switching the selection valve 12 to the suction port 12b, an atmospheric air will be introduced into the vacuum chamber 2, whereby vacuum destruction will occur in the process space 2a.

A process gas supply part 13 is connected to a coupling member 16 via a flow rate regulating valve 14 and an opening and closing valve 15. By actuating the process gas supply part 13, process gas for generating the plasma will be supplied from a lower face of the upper electrode 4 into the process space 2a. In case of conducting the plasma dicing, fluorine gas such as SF₆ (sulfur hexafluoride) is used, and in case of conducting the plasma-ashing, oxygen gas is used as the process gas. In case where the plasma process using the fluorine gas is conducted on the semiconductor wafer 5, it is desirable to set a narrow distance between the upper electrode 4 and the lower electrode 3 in the process space 2a, for improving efficiency of the process.

A high frequency power source 17 is electrically connected to the lower electrode 3 via a matching circuit 18, and by actuating the high frequency power source 17, high frequency voltage will be inputted between the lower electrode 3 and the upper electrode 4. By inputting the high frequency voltage in a state where the process gas is supplied, after the process space 2a has been evacuated, the plasma discharge will occur in the process space 2a, and the process gas supplied into the process space 2a will be in a plasma state. In this manner, the plasma process will be conducted on the semiconductor wafer 5 which has been placed on the lower electrode 3. The matching circuit 18 will match impedance of the plasma discharge circuit in the process space 2a to impedance of the high frequency power source 17, when the plasma has been generated. In the above described structure, the vacuum pump 11, the process gas supply part 13, the high frequency power source 17, and the matching circuit 18 constitute the plasma generating means which generates the plasma in the process space 2a.

Two independent sucking and blowing lines are connected to the lower electrode 3 for conducting vacuum suction and air blowing from a sucking and blowing through hole which is provided on an upper face of the lower electrode 3. Specifically, a first sucking and blowing line VB1 including a selection valve 24 is connected to a coupling member 27 which is communicated with an outer peripheral part of the lower electrode 3, and a second sucking and blowing line VB2 including a selection valve 25 is connected to a coupling member 28 which is communicated with a center part of the lower electrode 3.

In the first and second sucking and blowing lines VB1, VB2, a suction pump 26 is connected to respective suction ports 24a, 25a of the selection valves 24, 25, and an air pressure source 19 is connected to respective air supply ports 24b, 25b of the selection valves 24, 25 via opening and closing valves 22, 23 and regulators 20, 21. By switching the selection valves 24, 25 respectively to the suction port side and the air supply port side, the vacuum suction and air blowing can be selectively performed from the through hole on the upper face of the lower electrode 3. On this occasion, by regulating the regulators 20, 21, it is possible to set the air from the air pressure source 19 at a desired pressure.

The upper electrode 4 and the lower electrode 3 are respectively provided with cooling holes for circulating cooling water therethrough. A cooling unit 29 is connected to the cooling hole of the lower electrode 3 via coupling members 30, 31, and to the cooling hole of the upper electrode 4 via coupling members 32, 33. By actuating the cooling unit 29, the cooling medium will be circulated in the cooling holes in the lower electrode 3 and the upper electrode 4, whereby the lower electrode 3 and the upper electrode 4 will be prevented from being overheated by heat in the event of the plasma process.

In the above described structure, the elevation actuating part 7, the vacuum pump 11, the selection valve 12, the flow rate regulating valve 14, the opening and closing valve 15, the high frequency power source 17, the matching circuit 18, the opening and closing valves 22, 23, the selection valves 24, 25, and the suction pump 26 are controlled by a control part 10. When the control part 10 controls the elevation actuating part 7, the upper electrode 4 will be moved upward. When the control part 10 controls the vacuum pump 11 and the selection valve 12, evacuation and vacuum destruction in the process space 2a will be performed.

When the control part 10 controls the flow rate regulating valve 14 and the opening and closing valve 15, the supply of the process gas to the process space 2a will be switched on or off, and the flow rate of the gas will be regulated. Moreover, when the control part 10 controls the selection valves 24, 25, and the suction pump 26, timing of vacuum suction from the upper face of the lower electrode 3 will be controlled. Further, when the control part 10 controls the selection valves 24, 25 and the opening and closing valves 22, 23, timing of the air blowing from the upper face of the lower electrode 3 will be controlled.

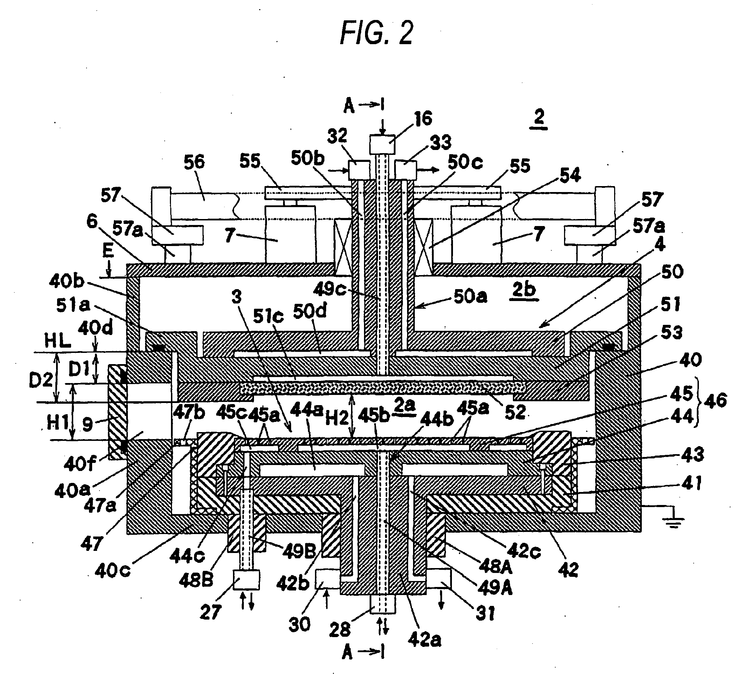

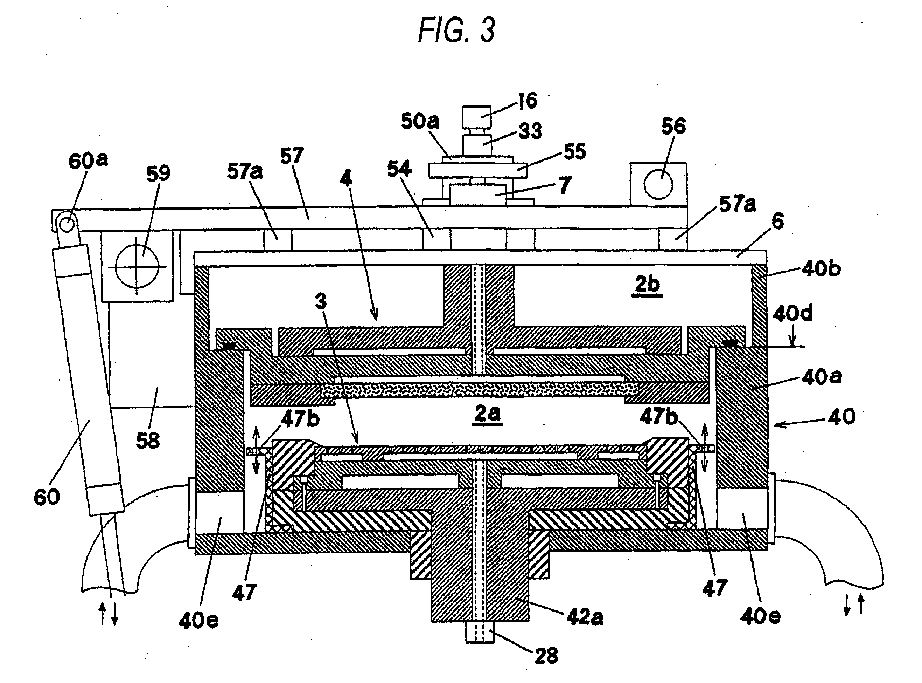

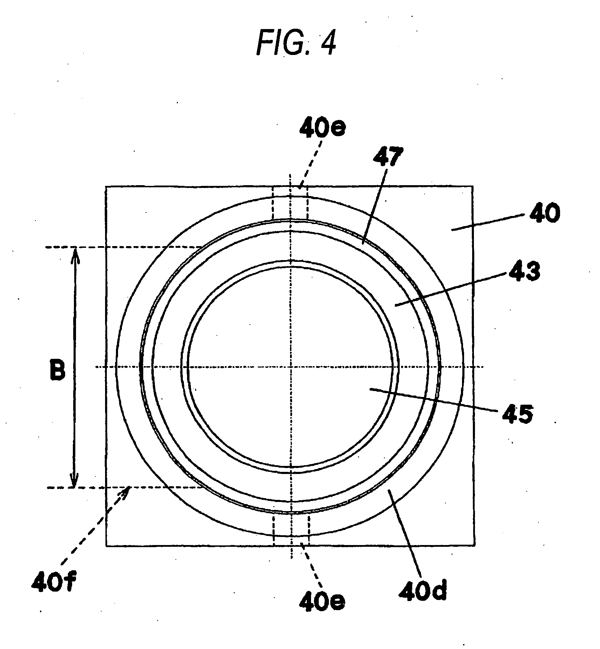

Then, referring to Figs. 2, 3, 4 and 5, structure of the vacuum chamber 2 will be described in detail. Fig. 3 is a sectional view taken along a line A-A in Fig. 2. In Figs. 2 to 4, a chamber container 40 which is a main body of the vacuum chamber 2 is a cylindrical container formed by circularly cutting and removing an inside of a rectangular block which is in a substantially square shape in a plan view (See Fig. 4). The chamber container 40 has a side wall part 40a continued in an annular shape, on its outer peripheral part.

As shown in Fig. 2, an upper part of the side wall part 40a is defined as a side wall upper part 40b having a different wall thickness. The side wall upper part 40b extends upwardly from an intermediate level HL which is set at a lower position than an upper end face E of the side wall part 40a. An annular part having a step difference is formed between a lower part of the side wall part 40a and the side wall upper part 40b, and defined as a hermetically sealing face 40d in an annular shape, which is adapted to be contacted with an outer edge portion 51 a radially extended from the upper electrode 4, in a state where the upper electrode 4 has been lowered. In this embodiment, the hermetically sealing face 40d is formed at the intermediate level HL which is positioned lower than the upper end face E of the side wall part 40a.

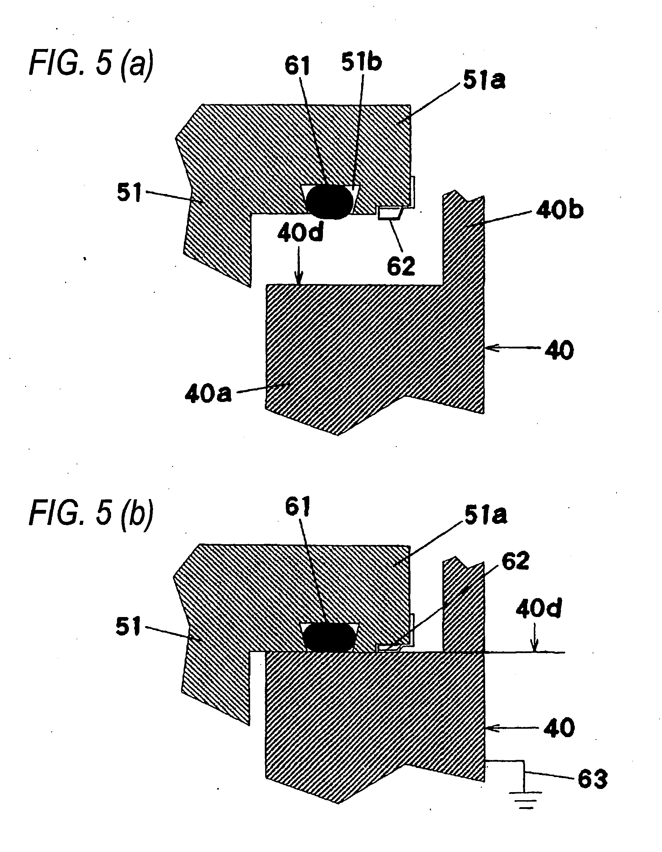

As shown in Fig. 5, a seal member 61 is fitted to a seal fitting groove 51b which is formed on a bottom face of the outer edge portion 51 a, and further, an electrically conductive fin 62 is provided on the bottom face of the outer edge portion 51a. When the upper electrode 4 has been lowered, the seal member 61 is pressed onto the hermetically sealing face 40d, whereby the process space 2a will be hermetically sealed from the exterior. At the same time, the conductive fin 62 will be pressed onto the hermetically sealing face 40d, whereby an intermediate plate 51 of the upper electrode 4 will be electrically continued to the chamber container 40 which is grounded to a grounding part 63.

The lower electrode 3 which carries the semiconductor wafer 5 on its upper face is disposed in a bottom part 40c which is surrounded by the side wall part 40a. A supply port 40f for putting the work in or out and having an opening height H1 and an opening width B (See Fig. 4), is formed in the side wall part 40a, in such a manner that a lower end of the supply port may be aligned with a level of the upper face of the lower electrode 3. In this embodiment, an upper end of the supply port 40f is positioned lower than the hermetically sealing face 40d of the side wall part 40a by a determined distance D1. In short, the hermetically sealing face 40d is formed in the side wall part 40a at a higher position than the supply port 40f. The door 9 for hermetically sealing the supply port 40f is provided on an outer face of the side wall part 40a. By moving the door 9 by means of a door opening and closing mechanism (not shown), the door 9 will be freely opened or closed.

Now, structure of the lower electrode 3 will be described. An electrode mounting part 42 which has a shaft portion 42a extended downward through a dielectric body 41 is held on an upper face of the bottom part 40c. The shaft portion 42a passes the bottom part 40c downwardly through a dielectric body 43. An electrode member 46 integrally composed of a cooling plate 44 and a sucking member 45 is mounted on an upper face of the electrode mounting part 42 in a detachable manner. The electrode member 46 is surrounded with the dielectric body 43, and further, a shield member 47 formed of metal such as aluminum is provided between outer peripheral faces of the dielectric bodies 41, 43 and an inner peripheral face of the side wall part 40a.

The shield member 47 is a substantially cylindrical member having such a shape that the outer peripheral faces of the dielectric bodies 41, 43 may be engaged therewith. The shield member 47 has a flange portion 47a which is extended radially outwardly at a level of an upper face of the sucking member 45 so as to close a gap between the side wall part 40a and the dielectric body 43. The shield member 47 has a function of shielding gaps between the side wall part 40a and the dielectric bodies 41, 43 thereby to prevent abnormal discharge. The flange portion 47a is formed with air ports 47b passing it though in a vertical direction. Accordingly, as shown in Fig. 3, communication of the air between the process space 2a above the lower electrode 3 and air supply / exhaust holes 40e which are formed in a lower part of the side wall part 40a and connected to the selection valve 12 will be permitted.

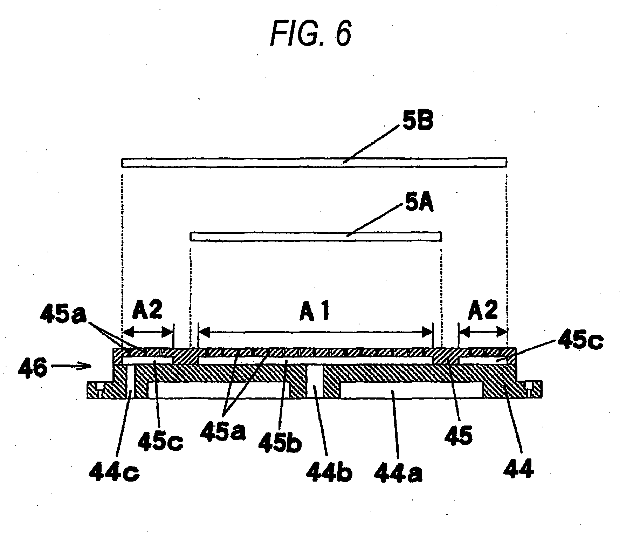

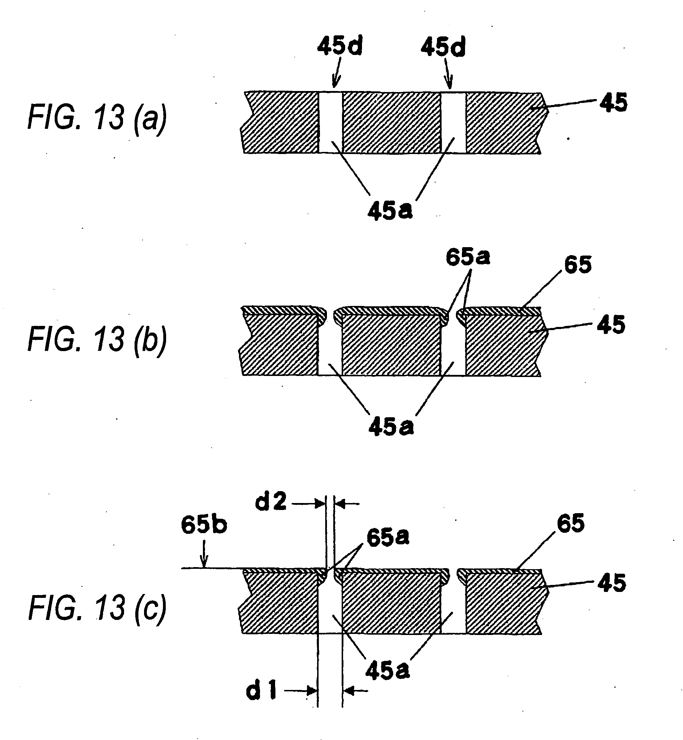

Interior structure of the lower electrode 3 will be described referring to Figs. 6, 7 and 8. To begin with, the electrode member 46 of the lower electrode 3 will be described. The electrode member 46 has a function of coming into contact with a lower face of the semiconductor wafer 5 to be processed, thereby to hold the semiconductor wafer by suction. As shown in Fig. 6, the electrode member 46 is formed by blazing the sucking member 45 to an upper face of the cooling plate 44. The sucking member 45 is a plate-like member produced from an electrically conductive body such as aluminum by cutting it in a substantially disc-like shape, and provided with a plurality of through holes 45a on its upper face. These through holes 45a are communicated with a center space 45b and an outer circumferential space 45c which are formed below a bottom face of the sucking member 45. A dielectric film sprayed with alumina, which is dielectric substance, is formed on the upper face of the sucking member 45, as described below. This dielectric film is in such a shape that edges of hole parts 45d (See Fig. 13) of the through holes 45a which open on the upper face of the sucking member 45 may be covered therewith.

The center space 45b and the outer circumferential space 45c are respectively provided corresponding to two types of the semiconductor wafers 5, namely, a small-sized semiconductor wafer 5A and a large-sized semiconductor wafer 5B, which are objects to be processed by plasma. In a state where the semiconductor wafer 5A is placed on the electrode member 46, a range to be covered with the semiconductor wafer 5A is a center area A1, and the center space 45b is formed in a round shape having a diameter size corresponding to the center area A1. In contrast, in a state where the semiconductor wafer 5B is placed on the electrode member 46, an outer circumferential area A2 which is positioned in an outer circumferential part of the center area A1 is covered with the semiconductor wafer 5B as well as the center area A1. The outer circumferential space 45c is formed in an annular shape having a diameter size corresponding to the outer circumferential area A2.

In a state where the sucking member 45 and the cooling plate 44 have been integrally bonded to each other, the center space 45b is communicated with a center through hole 44b which is formed in a center part of the cooling plate 44, and the outer circumferential space 45c is communicated with a side through hole 44c which is formed in an outer edge part of the cooling plate 44. Moreover, a cooling space 44a in an annular shape for circulating cooling water is formed below a bottom face of the cooling plate 44.

In a state where the electrode member 46 has been mounted on the electrode mounting part 42, the center space 45b is communicated with the coupling member 28, as shown in Fig. 2, by way of the center through hole 44b and an air pipe 49A which is inserted passing through the shaft portion 42a in a vertical direction. The outer circumferential space 45c is communicated with the coupling member 27 by way of the side through hole 44c and an air pipe 49B which is inserted into a dielectric body 48 passing through the dielectric body 41 and the bottom part 40c. The cooling space 44a is communicated with the coupling members 30, 31 by way of cooling medium channels 42b, 42c which are formed in the shaft portion 42a.

The two sucking and blowing lines VB 1 and VB2 as shown in Fig. 1 are respectively connected to the coupling members 27, 28, whereby vacuum suction through the through holes 45a in the center area A1 and the outer circumferential area A2 as shown in Fig. 6, and air blowing of normal pressure can be conducted at desired timings. In this manner, it is possible to hold by suction and release the semiconductor wafers 5A and 5B which have different diameter sizes, by means of the common electrode 46.

Specifically, in case where the semiconductor wafer 5A is the object to be processed, only the center space 45b will be sucked, whereby the semiconductor wafer 5A will be sucked and held by the sucking member 45. In order to release the suction of the semiconductor wafer 5A, the normal pressure air will be supplied into the center space 45b to perform air blowing through the through holes 45a, whereby the semiconductor wafer SAwill be removed from the upper face of the sucking member 45.

On the other hand, in case where the semiconductor wafer 5B is the object to be processed, both the center space 45b and the outer circumferential space 45c will be sucked, whereby the semiconductor wafer 5B will be sucked and held by the sucking member 45. In order to release the suction of the semiconductor wafer 5B, the normal pressure air will be first supplied into the center space 45b, and then, after a time difference, the normal pressure air will be supplied into the outer circumferential space 45c. Accordingly, the center part of the wafer can be first removed, and it is possible to smoothly remove the wafer with a small amount of air blow in a short time, even in case where the large-sized semiconductor wafer 5B is processed.

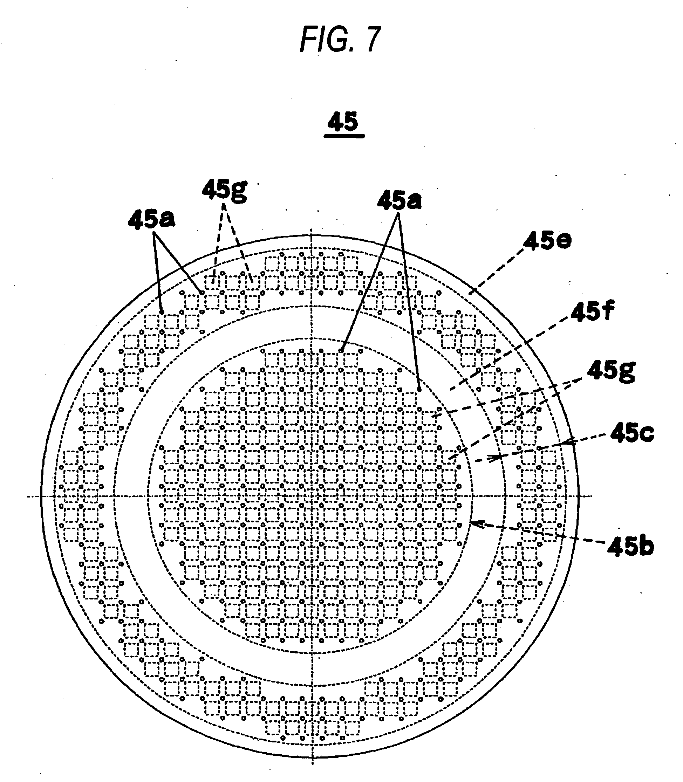

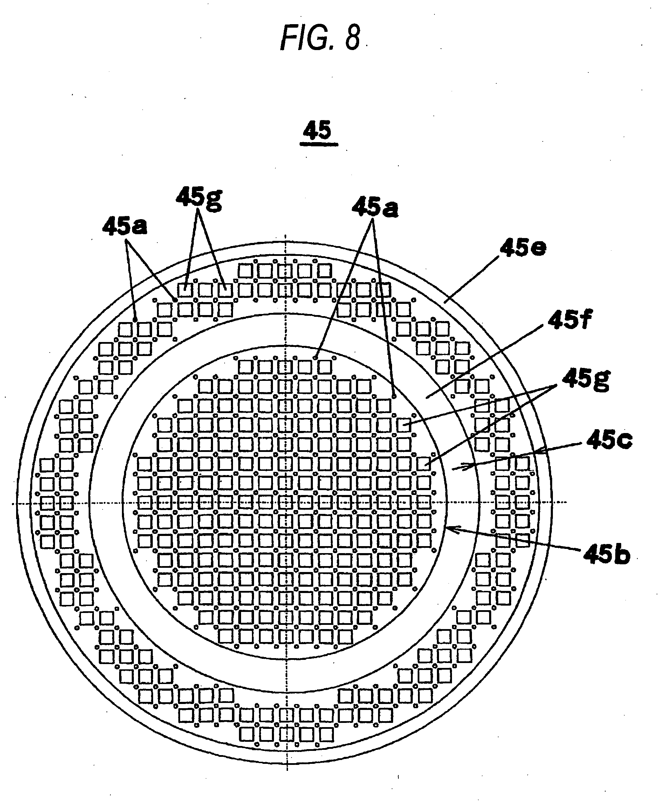

Then, referring to Figs. 7 and 8, a shape of the sucking member 45 to be employed in the electrode member 46 will be described in detail. Figs. 7 and 8 respectively show the upper face and the bottom face of the sucking member 45. In Figs. 7 and 8, the center space 45b in a round shape, and the outer circumferential space 45c in an annular shape which is positioned at the outer circumference of the center space 45b are formed below the bottom face of the sucking member 45 in a disc-like shape, by engraving the sucking member 45 to respectively determined depths. An outer edge of the outer circumferential space 45c is separated from the outer peripheral face of the sucking member by a first annular bonding face 45e. The center space 45b is separated from the outer circumferential space 45c by a second annular bonding face 45f.

The through holes 45a are formed in a grid pattern, within the center space 45b and the outer circumferential space 45c. Moreover, island bonding faces 45g each having a square shape enclosed by four adjacent through holes 45a of these through holes 45a are formed also in a grid pattern. Bottom faces of the island bonding faces 45g are in a same plane as the first annular bonding face 45e and the second annular bonding face 45f On occasion of bonding the sucking member 45 to the cooling plate 44 by blazing, the first annular bonding face 45e, the second annular bonding face 45f, and the island bonding faces 45g are bonded by blazing to bonding faces of the cooling plate 44 corresponding to these bonding faces.

In the structure for forming the integral electrode member 46 by bonding the sucking member 45 to the cooling plate 44 by blazing, the island bonding faces 45g are arranged as uniformly and densely as possible, within the center space 45b and the outer circumferential space 45c, in addition to the first annular bonding face 45e and the second annular bonding face 45f Accordingly, rigid bonding strength can be secured, and at the same time, heat generated at the plasma processing can be efficiently transmitted from the sucking member 45 to the cooling plate 44. Moreover, in case of forming the bonding faces on the lower face of the sucking member 45, additional bonding faces which interconnect the first annular bonding face 45e and the second annular bonding face 45f may be formed in a manner of traversing the outer circumferential space 45c in a radial direction.

Now, the upper electrode 4 and an elevating mechanism for moving the upper electrode 4 up and down will be described. As shown in Fig. 2, the upper electrode 4 includes a holding member 50 which is formed of an electrically conductive material such as aluminum and has a shaft portion 50a extended in an upward direction. An intermediate plate 51 which is also formed of an electrically conductive material in a disc-like shape is fixed to a lower face of the holding member 50. Further, a shower plate 52 whose outer circumference is held by a holding ring 53 is fitted to a lower face of the intermediate plate 51.

The intermediate plate 51 is provided with an outer edge portion 51a which is extended radially outwardly and adapted to come into contact with the hermetically sealing face 40d. The shower plate 52 and the holding ring 53 which are positioned inward of the outer edge portion 51a are projected downward by a projecting length D2, and therefore, lower faces of the shower plate 52 and the holding ring 53 are defined as a projected face which is projected lower than the lower face of the outer edge portion 51a.

The shaft portion 50a is held so as to move up and down by a bearing part 54 which is provided on the upper plate 6, and coupled to an elevation actuating part 7 which is arranged on the upper plate 6, by way of a coupling member 55. The upper plate 6 and the bearing part 54 function as a support mechanism which holds the upper electrode 4 so as to move up and down. The upper electrode 4 will be moved up and down by actuating the elevation actuating part 7, and at the lowered position of the upper electrode 4, the outer edge portion 51 a of the intermediate plate 51 will be brought into contact with the hermetically sealing face 40d which is formed on the chamber container 40. Accordingly, the process space 2a having a height H2 will be formed between the electrode member 46 of the lower electrode 3 and the shower plate 52 of the upper electrode 4.

At this moment, a normal pressure space 2b which has always the same pressure as the outside air pressure is formed above the upper electrode 4 in the vacuum chamber 2. Therefore, in case where high frequency voltage is inputted between the upper electrode 4 and the lower electrode 3 to generate plasma in the process space 2a, abnormal discharge will not happen above the upper electrode 4. Accordingly, loss of waste power and scattering of the plasma discharge attributed to the abnormal discharge can be prevented, while securing the space for elevation which is required for constructing the upper electrode 4 so as to move up and down, and so, it is possible to efficiently perform stabilized plasma process.

In the upper electrode 4, the distance between the lower face of the outer edge portion 51a and the lower face of the holding ring 53, that is, the projecting length D2 of the projected face which is projected from the lower face of the outer edge portion 51a is so set as to be larger than the distance D 1 between the upper end of the supply port 40f and the hermetically sealing face 40d which is positioned just above the supply port 40f. Therefore, in the lowered state of the upper electrode 4, the lower face of the holding ring 53 is positioned lower than the upper end of the supply port 40f. Accordingly, it is possible to set the distance H2 between the shower plate 52 and the sucking member 45 in the process space 2a, that is, a gap between the electrodes to be a narrow gap which is appropriate for efficiently conducting the plasma process on the semiconductor wafer 5 with fluorine gas.

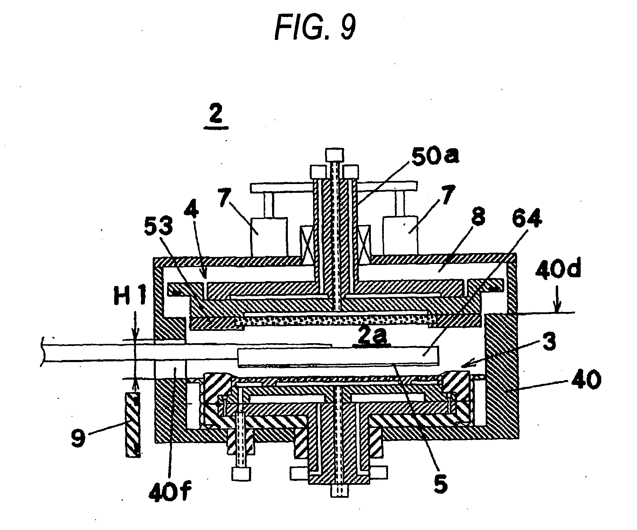

Then, in a state where the upper electrode 4 has been elevated by actuating the elevation actuating part 7, as shown in Fig. 9, the holding ring 53 is positioned above the supply port 40f. By opening the door 9 in this state, the supply port 40f will be opened, but the upper electrode 4 is not present within a range of the opening height H1 of the supply port 40f. Therefore, in the work conveying operation for conveying the semiconductor wafer 5 into or out of the process space 2a by means of a board conveying mechanism 64, the board conveying mechanism 64 will not interfere with the upper electrode 4.

In the plasma processing apparatus in this embodiment, by determining the sizes in such a manner that the projecting length D2 of the upper electrode 4 may be larger than the distance D1 in the chamber container 40, it is possible to secure the opening height H1 which is required for conducting the conveying operation with no hindrance, while realizing the narrow gap between the electrodes which is desirable for conducting the plasma process on the semiconductor wafer 5 with high efficiency.

In the above described structure, the upper electrode 4 has the outer edge portion 51a in an annular shape which can be brought into contact with the hermetically sealing face 40d, and the projected face which is projected downward from the lower face of the outer edge portion 51 a inward of the outer edge portion 51 a. Moreover, the elevation actuating part 7 is so constructed as to bring the outer edge portion 51a into contact with the hermetically sealing face 40d, thereby to form the hermetically sealed process space 2a between the lower electrode 3 and the upper electrode 4. Further, this elevating mechanism is mounted on the support mechanism which holds the upper electrode 4 so as to move up and down. By employing the above described structure, the simplified and compact structure of the vacuum chamber 2 can be realized.

In Fig. 2, there is formed a gas space 51c below the lower face of the intermediate plate 51 opposed to the upper face of the shower plate 52. The gas space 51c is communicated with the coupling member 16 by way of an air pipe 49C passing through the shaft portion 50a. The coupling member 16 is connected to the opening and closing valve 15, as shown in Fig. 1. The process gas supplied from the process gas supply part 13 will be blown out through minute holes of the shower plate 52 into the process space 2a, after it has arrived at the gas space 51c.

A cooling jacket 50d for circulation of the cooling medium is formed below a lower face of the holding member 50. The cooling jacket 50d is communicated with the coupling members 32, 33 by way of cooling medium channels 50b, 50c which are formed inside the shaft portion 50a. The coupling members 32, 33 are connected to the cooling unit 29 as shown in Fig. 1. By actuating the cooling unit 29, the cooling medium will be circulated in the cooling jacket 50d thereby to cool the intermediate plate 51 which has been heated up by the plasma process, and thus, overheating will be prevented.

Then, an opening and closing mechanism for opening and closing the upper plate 6 together with the upper electrode 4 will be described. In Figs. 2 and 3, two opening and closing members 57 are fixed to the upper face of the upper plate 6 in a state contacted with an upper end face E of the side wall upper part 40b, by means of connecting blocks 57a. A grasping rod 56 is connected to one ends (at a right side in Fig. 3) of the two opening and closing members 57 in a manner of bridging them. A hinge block 58 is fixed to a left side face of the chamber container 40, and a horizontal hinge shaft 59 is pivotally supported by the hinge block 58.

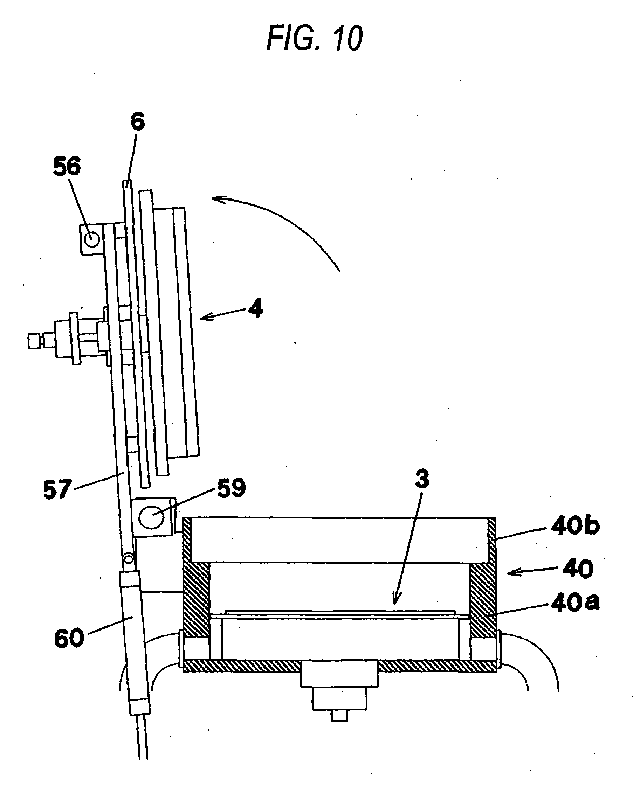

The other ends of the opening and closing members 57 are extended to an outside of the upper plate 6, and pivotally supported by the hinge shaft 59. Moreover, a damper 60 is coupled to the other ends of the opening and closing members 57 by way of a pin 60a. The opening and closing members 57, the hinge block 58, and the hinge shaft 59 constitute a hinge mechanism which rotates the upper plate 6 to open or close. In order to open the upper plate 6, the grasping rod 56 will be grasped and lifted upward, and the upper plate 6 together with the upper electrode 4 will be rotated around the hinge shaft 59, as shown in Fig. 10

In this manner, an open part on the upper face of the chamber container 40 will be completely opened, thus enabling maintenance work such as exchanging the electrode member in the lower electrode 3, cleaning the interior, and so on, to be performed with excellent workability. Specifically, in this embodiment, the support mechanism which holds the upper electrode 4 is mounted so as to rotate about a horizontal axis by means of the above described hinge mechanism. The damper 60 has a function of decreasing holding power which is required for holding the upper electrode 4 and weight of the upper plate 6 itself, on occasion of closing the upper plate 6 which has been opened, thereby to facilitate the opening and closing operations.

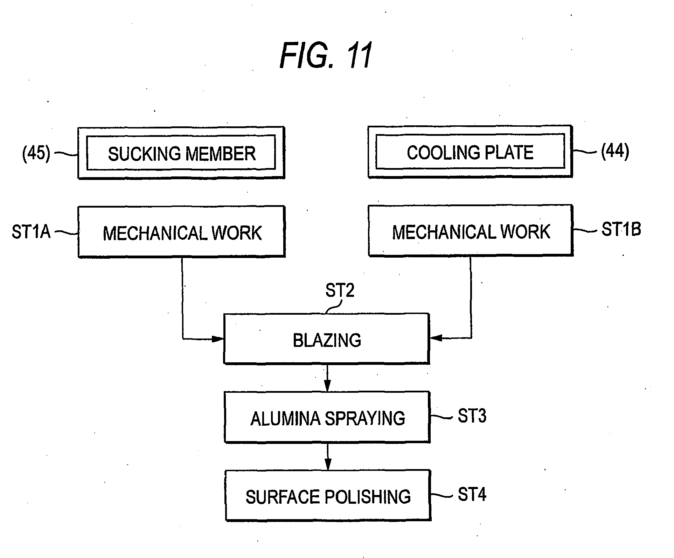

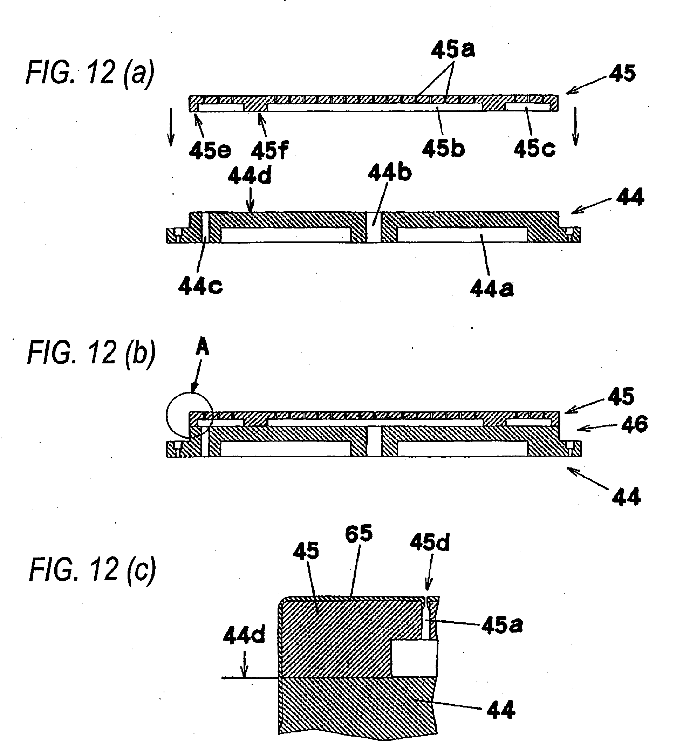

Referring now to Figs. 11, 12, and 13, a process for producing the electrode member 46 which is used in the lower electrode 3 will be described. In the drawings, there is shown the process for producing the electrode member 46 to be mounted on the lower electrode 3, by integrally forming the sucking member 45 and the cooling plate 44 which constitute the electrode member 46. As a first step, the cooling plate 44 and the sucking member 45 as individual components will be respectively produced by mechanical works (ST1A), (ST1B). Specifically, as shown in Fig. 12(a), the sucking member 45 will be produced, by forming the through holes 45a, the center space 45b, the outer circumferential space 45c, the first annular bonding face 45e, and the second annular bonding face 45f, in a disc-like member. In the same manner, the cooling plate 44 will be produced by forming the cooling jacket 44a, the center through hole 44b, the side through holes 44c and the blazing face 44d by mechanical work. In the process, the mechanical works are conducted so that the bottom face of the sucking member 45 and the blazing face 44d of the cooling plate 44 may be the same in a planar shape.

Then, blazing will be performed (ST2). Specifically, as shown in Figs. 12(a), (b), the first annular bonding face 45e and the second annular bonding face 45f will be bonded by blazing to the blazing face 44d, whereby the cooling member 44 and the sucking member 45 will be integrally formed. Thereafter, alumina spraying will be conducted (ST3). Specifically, alumina which is dielectric material is sprayed over the upper face of the sucking member 45 which has been integrally bonded to the cooling plate 44, thereby to form a dielectric film. Specifically, as shown in Fig. 13(b), an alumina sprayed film 65 is formed on the upper face of the sucking member 45 which is in a state as shown in Fig. 13(a).

On this occasion, a part of the sprayed film 65 will fall into and adhere to the through holes 45a, in hole parts 45d of the through holes 45a which open on the upper face of the sucking member 45 in a plate-like shape. As the results, the melted alumina will adhere to and cover edges of the hole parts 45d thereby to form dielectric films 65a attached to the hole parts. A range to be sprayed with alumina is not limited to the upper face of the sucking member 45. As shown in Fig. 13(c), the sprayed film 65 will be formed in a range including an entire area of a side end face of the sucking member 45 and a part of a side end face of the cooling plate 44 (an area lower than the blazing face 44d by a determined width).

Thereafter, surface polishing of the alumina sprayed face will be conducted (ST4). Specifically, as shown in Fig. 13(c), the sprayed film 65 which has been sprayed over the upper face of the sucking member 45 will be mechanically polished thereby to form a smooth covered face 65b. Through this mechanical polishing, upper faces of the dielectric films 65a covering the hole parts 45d of the through holes 45a will be partially removed, and an effective hole diameter d2 of the through holes 45a at the hole parts will be smaller than the hole diameter d1 at which the through holes 45a have been originally worked. Therefore, it is possible to make the through holes 45a by drilling at the hole diameter d1 which is larger than the hole diameter d2 required for appropriately conducting the vacuum suction and air blowing. In this manner, it is possible to provide the through holes having a minute diameter, without necessity of drilling minute holes which are very difficult to work.

To summarize, the process for producing the electrode member 46 as described above includes a through hole forming step for forming a plurality of the through holes 45a in the sucking member 45, a spraying step for spraying alumina over the upper face of the sucking member 45, thereby to form the sprayed films 65 so as to cover the edges of the hole parts of the through holes 45a which open on the upper face of the sucking member 45, and a surface polishing step for mechanically polishing the surface of the sucking member 45 covered with the sprayed film 65.

As described above, by covering the upper face of the lower electrode 3 to be exposed to plasma, with the dielectric film in a shape as described above, the following advantages will be obtained. In the conventional apparatus, because a metal face has been exposed on an almost entire surface of the electrode member, the metal face of the electrode member has been exposed to plasma, on every occasion that cleaning for removing deposits adhered to the vacuum chamber by plasma ashing is conducted. For this reason, the surface of the electrode member has been removed by spattering effect of the plasma, whereby life of components of the electrode member has been shortened, which lead to the fact that the cost for the components has been increased, and obstacles scattered by the spattering have adhered to the inner face of the apparatus to contaminate the interior.

In contrast, in this embodiment, the upper face of the electrode member 46 is covered with the dielectric film, and the metallic surface is not directly exposed to plasma. Accordingly, generation of the scattered obstacles which happens, when the metal is removed by spattering, will be restrained, and contamination of the interior of the apparatus by the adhesion of the scattered obstacles will be prevented. Therefore, it is possible to prolong the life of the components of the electrode member in the lower electrode.

Further, in this embodiment, by forming the dielectric films 65a in a shape of covering the edges of the hole parts 45d, it is possible to increase resistance to etching at the edges of the hole parts of the through holes 45a, thereby to locally prolong the life of the components, and at the same time, to prevent abnormal discharge which is likely to occur at the edges. Moreover, because the side end face of the sucking member 45 and a part of the side end face of the cooling plate 44 along the outer peripheral face of the electrode member 46 are covered with the sprayed film 65, occurrence of the abnormal discharge near the outer circumference of the lower electrode 3 can be prevented.

Further, in the process of mounting the electrode member 46 to the lower electrode 3 for repeatedly conducting the plasma process on the semiconductor wafer 5, the surface of the sucking member 45 will be damaged by the plasma etching, and the covered face 65b will be made coarse. When the damage of the surface proceeds, the electrode member 46 becomes unusable, and must be exchanged with a new electrode member 46. Conventionally, the electrode member 46 having damage on the surface has been disposed of as a waste component exceeding the useful life. However, the electrode member 46 in this embodiment can be reused, by conducting the following recycling process.

In this recycling process, the sprayed film 65 on the upper face of the sucking member 45 in the electrode member 46 which has been used will be removed by blasting method or the like (a film removing step). Then, the sprayed film 65 will be again formed by spraying in the same manner as shown in Fig. 13(b), on the upper face of the sucking member 45 from which the sprayed film 65 has been removed (a re-spraying step). Thereafter, the surface of the sucking member 45 will be again mechanically polished, whereby the smooth covering face 65b will be formed on the sprayed film 65 on the upper face of the sucking member 45, as shown in Fig. 12(c), to make the electrode member reusable. In this manner, it is possible to repeatedly use the electrode member of high cost which has been produced through complicated mechanical works and bonding steps, and to decrease running cost of the plasma processing apparatus.

This application is based upon and claims the benefit of priority of Japanese Patent Application No..2005-263409 filed on September 12, 2005.

### Industrial Applicability

The plasma processing apparatus of the invention has an advantage that the stabilized plasma process can be efficiently performed, and the plasma processing apparatus is useful in conducting the plasma process on a work in a plate-like shape, such as a semiconductor wafer.

## Claims

1. A plasma processing apparatus for conducting plasma process on a plate-like shape work, comprising
a vacuum chamber (2) including a cylindrical container (40) as a main body which has a side wall part (40a) continued in an annular shape, a supply port (40f) which is opened in said side wall part for putting into and taking out the work, and a hermetically sealing face (40d) which is formed in said side wall part at a position higher than said supply port,
a door (9) for hermetically sealing said supply port,
a lower electrode (3) which is disposed in a bottom part of said vacuum chamber surrounded by said side wall part, said work being adapted to be placed on an upper face of said lower electrode,
an upper electrode (4) provided with an annular outer edge portion (51a) which is brought into contact with said hermetically sealing face,
an elevating mechanism (7,54) for moving an electrode up and down to bring said outer edge portion into contact with said hermetically sealing face thereby to form a hermetically sealed process space between said lower electrode and said upper electrode, and
plasma generating means (11,13,17,18) for generating plasma in said process space;
**characterized in that** said upper electrode is further provided with a projected face which is projected downward from its lower face inward of said outer edge portion to a position lower than a lower face of the outer edge portion and said elevating mechanism is adapted to move said upper electrode.

2. A plasma processing apparatus as claimed in claim 1, wherein a projected length of said projected face which is projected from the lower face of said outer edge portion (51a) is larger than a length from an upper end of said supply port (40f) to said hermetically sealing face (40d) which is positioned just above said supply port, whereby said projected face is positioned lower than the upper end of said supply port, in a state where said outer edge portion is in contact with said hermetically sealing face.

3. A plasma processing apparatus as claimed in claim 2, wherein said hermetically sealing face (40d) is formed at an intermediate level (HL) which is positioned lower than an upper end face of said side wall part (40a) and further, a support mechanism (6,54) which holds said upper electrode (4) so as to move up and down is provided on the upper end face of said side wall part.

4. A plasma processing apparatus as claimed in claim 3, wherein said elevating mechanism (7,54) is mounted on said support mechanism (6,54).

5. A plasma processing apparatus as claimed in claim 4, wherein said support mechanism (6,54) is mounted so as to rotate about a horizontal axis by means of a hinge mechanism.

## Patentansprüche

1. Plasmaverarbeitungsvorrichtung zum Durchführen eines Plasmaverfahrens an einem plattenförmigen Werkstück, die umfasst:
eine Vakuumkammer (2), die als Hauptkörper einen zylindrischen Behälter (40) aufweist, der einen Seitenwandteil (40a) umfasst, der in Ringform weiterverläuft, einen Zuleitungsanschluss (40f), dessen Öffnung sich in dem Seitenwandteil befindet, damit das Werkstück hineingegeben und herausgenommen werden kann, und eine hermetisch abdichtende Fläche (40d), die an einer höheren Position als der Zuleitungsanschluss in dem Seitenwandteil ausgebildet ist,
eine Tür (9), um den Zuleitungsanschluss hermetisch abzudichten,
eine untere Elektrode (3), die in einem Bodenteil der Vakuumkammer angeordnet und von dem Seitenwandteil umgeben ist, wobei das Werkstück dazu angepasst ist, auf einer oberen Fläche der unteren Elektrode platziert zu werden,
eine obere Elektrode (4), die mit einem ringförmigen Außenkantenabschnitt (51 a) versehen ist, der in Kontakt mit der hermetisch abdichtenden Fläche gebracht wird,
einen Hebemechanismus (7, 54) zum Auf- und Abbewegen einer Elektrode, so dass der Außenkatenabschnitt in Kontakt mit der hermetisch abdichtenden Fläche gebracht werden kann, wodurch ein hermetisch abgedichteter Verarbeitungsraum zwischen der unteren Elektrode und der oberen Elektrode gebildet wird, und
eine Plasmaerzeugungseinrichtung (11, 13, 17, 18) zum Erzeugen von Plasma in dem Verarbeitungsraum;
**dadurch gekennzeichnet, dass** die obere Elektrode weiterhin über eine vorstehende Fläche verfügt, die von der unteren Fläche nach unten einwärts von dem Außenkantenabschnitt bis zu einer Position vorsteht, die niedriger als eine untere Fläche des Außenkantenabschnitts ist, und wobei der Hebemechanismus dazu angepasst ist, die obere Elektrode zu bewegen.

2. Plasmaverarbeitungsvorrichtung nach Anspruch 1, wobei eine vorstehende Länge der vorstehenden Fläche, die von der unteren Fläche des Außenkantenabschnitts (51 a) vorsteht, größer ist als eine Länge von einem oberen Ende des Zuleitungsanschlusses (40f) bis zu der hermetisch abdichtenden Fläche (40d), die direkt oberhalb des Zuleitungsanschlusses angeordnet ist, wodurch die vorstehende Fläche in einem Zustand, in dem der Außenkantenabschnitt in Kontakt mit der hermetisch abdichtenden Fläche steht, niedriger als das obere Ende des Zuleitungsanschlusses positioniert ist.

3. Plasmaverarbeitungsvorrichtung nach Anspruch 2, wobei die hermetisch abdichtende Fläche (40d) auf einer Zwischenebene (HL) ausgebildet ist, die niedriger als eine obere Endfläche des Seitenwandteils (40a) positioniert ist und wobei weiterhin ein Haltemechanismus (6, 54), der die obere Elektrode (4) auf- und abbewegbar hält, an der unteren Endfläche des Seitenwandteils bereitgestellt ist.

4. Plasmaverarbeitungsvorrichtung nach Anspruch 3, wobei der Hebemechanismus (7, 54) an dem Haltemechanismus (6, 54) montiert ist.

5. Plasmaverarbeitungsvorrichtung nach Anspruch 4, wobei der Haltemechanismus (6, 54) so montiert ist, dass er mithilfe eines Drehlagerungsmechanismus um eine horizontale Achse gedreht werden kann.

## Revendications

1. Appareil de traitement au plasma pour réaliser un traitement au plasma d'une pièce à traiter en forme de plaque, comprenant :
une chambre sous vide (2) comportant un récipient cylindrique (40) comme corps principal, qui possède un élément de cloison latérale (40a) se prolongeant en une forme annulaire, un port d'alimentation (40f) ouvert dans ledit élément de cloison latérale et permettant de placer et d'enlever la pièce, et une face à scellement hermétique (40d) formée dans ledit élément de cloison latérale à une position plus élevée que ledit port d'alimentation,
une porte (9) pour sceller hermétiquement ledit port d'alimentation,
une électrode inférieure (3) agencée dans une partie du fond de ladite chambre sous vide, entourée par ledit élément de cloison latérale, ladite pièce étant adaptée pour être placée sur une face supérieure de ladite électrode inférieure,
une électrode supérieure (4) comportant une partie de bord externe annulaire (51a) qui est mise en contact avec ladite face à scellement hermétique,
un mécanisme de levage (7, 54) pour déplacer une électrode vers le haut et vers le bas afin d'amener ladite partie de bord externe en contact avec ladite face à scellement hermétique, formant ainsi un espace de traitement scellé hermétiquement entre ladite électrode inférieure et ladite électrode supérieure, et
des moyens de génération de plasma (11, 13, 17, 18) pour générer un plasma dans ledit espace de traitement ;
**caractérisé en ce que** ladite électrode supérieure est en outre pourvue d'une face saillante projetée vers le bas depuis sa face inférieure, à l'intérieur de ladite partie de bord externe, vers une position plus basse qu'une face inférieure de la partie de bord externe, et **en ce que** ledit mécanisme de levage est adapté pour déplacer ladite électrode supérieure.

2. Appareil de traitement au plasma selon la revendication 1, dans lequel une longueur projetée de ladite face saillante projetée depuis la face inférieure de ladite partie de bord externe (51a) est supérieure à une longueur allant depuis une extrémité supérieure dudit port d'alimentation (40f) jusqu'à ladite face à scellement hermétique (40d) positionnée juste au-dessus dudit port d'alimentation, moyennant quoi ladite face saillante est positionnée plus bas que l'extrémité supérieure dudit port d'alimentation, dans un état où ladite partie de bord externe est en contact avec ladite face à scellement hermétique.

3. Appareil de traitement au plasma selon la revendication 2, dans lequel ladite face à scellement hermétique (40d) est conformée à un niveau intermédiaire (HL) situé plus bas qu'une face d'extrémité supérieure dudit élément de cloison latérale (40a), et dans lequel un mécanisme de support (6, 54) soutenant ladite électrode supérieure (4) pour la déplacer vers le haut et vers le bas est en outre pourvu sur la face d'extrémité supérieure dudit élément de cloison latérale.

4. Appareil de traitement au plasma selon la revendication 3, dans lequel ledit mécanisme de levage (7, 54) est monté sur ledit mécanisme de support (6, 54).

5. Appareil de traitement au plasma selon la revendication 4, dans lequel ledit mécanisme de support (6, 54) est monté de manière à pivoter autour d'un axe horizontal au moyen d'un mécanisme de charnière.
